# NEW EUROPEAN PATENT SPECIFICATION

(11) **EP 0 812 527 B2**
(45) Date of publication and mention of the opposition decision: **17.03.2004**
(45) Mention of the grant of the patent: 06.10.1999
(21) Application number: 96904196.1
(22) Date of filing: 01.03.1996
(51) Int. Cl.: H05K 5/06, H05K 3/00

(54) **SEALED PACKAGING FOR ENVIRONMENTAL PROTECTION OF ELECTRONICS**
ABGEDICHTETE VERPACKUNG ZUM SCHUTZ DER ELEKTRONIK GEGEN WITTERUNGSEINFLÜSSE
EMBALLAGE ETANCHE POUR LA PROTECTION DE DISPOSITIFS ELECTRONIQUES FACE AUX DANGERS DE L'ENVIRONNEMENT

(30) Priority: 02.03.1995 GB 9504218; 26.09.1995 GB 9519554
(43) Date of publication of application: 17.12.1997
(73) Proprietor: TYCO ELECTRONICS RAYCHEM N.V., 3010 Kessel-Lo (BE)
(72) Inventor: ERREYGERS, Jan, B-2180 Kalmthout (BE); VAN LEEUW, Luc, B-3540 Herk-de-Stad (BE); DELVAUX, Roger, B-3010 Kessel-Lo (BE); DIDDENS, Dirk, B-3001 Heverlee (BE); BUEKERS, Valere, B-3545 Zelem-Halen (BE)
(74) Representative: Jay, Anthony William
(86) International application number: PCT/GB1996/000456
(87) International publication number: WO 1996/027279

(56) References cited:
- WO-A-93/05635
- WO-A-94/18815
- WO-A-95/28072
- DE-A- 3 813 565
- GB-A- 2 180 415
- US-A- 4 634 207
- US-A- 5 319 522
- US-A- 5 347 084
- IEEE Standard Dictionary of Electrical and Electronics Terms, Second Edition, New York, 1977, page 706

## Description

This invention relates to environmental protection for active electronics. More specifically, this invention relates to sealed packaging for the environmental protection of active electronic circuit boards, e.g. for telecommunications.

Traditionally, most of the electronics in a telephony network has been located in the central office or in a few large electronic installations located remotely from the central office. These remote electronics are powered by power drawn from the power mains and backed up by battery power supplies. The electronics in the central office operate in an environment with a carefully regulated temperature and humidity to assure their proper operation. The remote electronics are usually also installed in vaults with controlled environments, or at least in enclosures that are maintained at a temperature above that of the outdoor environment by the large amount heat dissipated by the system.

Recent advances in digital signal processing have made possible new and more capable transmission systems. Many of these new systems have created a need to move the active electronic components in the telephone system away from a temperature controlled central office and out into the general environment where the components will be exposed to wide fluctuations in temperature and environmental pollutants. To gain the full advantage of these new transmission systems it is desirable to deploy the remote electronics in small units that are powered from a central point over the transmission media. These power efficient units generate very little heat and so are much more vulnerable to damage from moisture than was the case in the past because they lack the internal heating necessary to keep them dry. As a result there has been an increasing need for environmental protection of these low heat-generating active electronics systems. The typical small remote electronics units deployed in the telecommunications network will be installed by technicians with few tools and limited supervision. The service life of these electronics is expected to be many (e.g. 20) years.

Methods of encapsulating active electronic components are known. US-A-5319522, for example, describes a method of encapsulating a printed circuit board with electrical contacts leading from the circuit board. According to the prior art reference, an open ended sleeve of heat shrinkable PTFE material is slipped over the circuit board, prior to its encapsulation with insert injection moulded polymeric material. Heat is applied to the heat shrinkable material so that the openings at the ends of the sleeve become substantially smaller. In this manner, only minimal portions of the surface of the circuit board will be exposed to direct contact with flowable polymer during the insert injection moulding. The tightly conforming shape of the heat encapsulating shell around the circuit board substantially prevents flowable polymer from flowing inside the encapsulating sleeve to contact the portions of the circuit board which are not exposed to direct contact by flowable polymer during injection moulding. This means that the electronic components on the circuit board are protected from damage due to thermal shock, and the solder joints are substantially prevented from melting.

According to the present invention, there is provided a telecommunications active electrical circuit apparatus, comprising:
(a) a circuit board (1) having active components (8);
(b) an environmental gas and liquid barrier envelope (3,4) sealingly encapsulating at least part of said circuit board (1), wherein the envelope is flexible and is formed from one or more sheets (3,4), the edges of which are bonded or welded together to provide the said encapsulation of at least part of the circuit board; and
(c) one or more electrical conductors (2) extending from the circuit board (1) out of the flexible envelope (3,4);
characterised in that:
(i) the apparatus also comprises an electrical connector (6) for connecting the circuit board (1) to an external system, whereby said connector (6) is located outside the flexible barrier envelope (3,4) and, at least in use, is electrically connected to the circuit board (1) by means of the one or more electrical conductors (2) extending out of the flexible envelope (3,4); and
(ii) the apparatus also comprising a casing (17,19) which, at least in use, contains the electrical connector (6) and also sealingly encapsulates part only of the flexible envelope (3,4), and the exit of the or each electrical conductor (2) out of the envelope (3,4).

The invention has the advantage that because the circuit board is sealingly encapsulated in a flexible environmental gas and liquid barrier envelope, it is. normally well protected from such environmental hazards even when the apparatus is located remotely from the central office and the electrical or electronic components of the circuit board do not generate very much heat. This advantage is combined with the advantage that the electrical connection between the circuit board and an external system is via an external electrical connector which is itself electrically connected to the circuit board via one or more electrical conductors extending out of the sealed flexible envelope. This means that the circuit board may remain sealed from the environment even when, in use, electrical connections with the circuit board are made, broken or changed.

The invention, also has the advantage that, because the casing which contains the electrical connector also sealingly encapsulates part of the flexible envelope, and the exit of the or each electrical conductor out of the envelope, the exit of the electrical conductor(s) from the flexible envelope is sealed in a simple yet highly effective manner. This is advantageous because the exit for the electrical conductor(s) is normally the most difficult part of the flexible envelope to seal effectively. It has been found that when adhesives, mastics, and even high-performance sealing materials such as gels (as described below) are used to provide a seal between the electrical conductors and the flexible envelope, it often cannot be guaranteed that such a seal will not fail. The second aspect of the invention, and the preferred embodiment of the first aspect of the invention, overcome this problem by using a casing, which also contains (preferably sealingly) the electrical connector, to provide the required seal. The casing may, and preferably does, provide this seal by being sealed, itself, by means of sealing material (e.g. gel).

The electrical conductor(s) of the invention may comprise one or more wires and /or at least one flat cable. The electrical conductor(s) may, alternatively, be carried by a relatively narrow extension of the circuit board, which extends from a relatively wide main portion of the circuit board which carries the active components.

The flexible envelope may advantageously comprise a relatively wide portion which encapsulates the circuit board, or at least a main portion thereof, and extending from the wide portion a relatively narrow portion which encapsulates at least part of the or each electrical conductor. Preferably, the relatively narrow portion of the envelope extends into the casing which contains the electrical connector.

The flexible envelope is preferably substantially impervious to water, and more preferably is substantially impervious to water in both liquid and vapour phases. The envelope is preferably formed from polymeric material (e.g. polyester and/or polyethylene). Advantageously, the envelope wall(s) comprise(s) one or more layer(s) of polymeric material and one or more layer(s) of metal (e.g. aluminium). A particularly preferred envelope wall comprises a metal layer sandwiched between two polymeric layers. The presence of a metal layer normally makes the envelope wall(s) substantially impervious to water vapour. Any joins in the wall(s) of the envelope are preferably formed (and sealed) by heat-welding polymeric layers of the wall(s) together.

The flexible envelope preferably has the form of a sealed bag or the like. It is formed from one or more sheets, the edges of which are bonded or welded together.

For the avoidance of doubt, it should be noted that the electrical connector may comprise a single electrical connector or a plurality of electrical connectors, either joined together, or separate from each other.

The casing for the electrical connector preferably comprises at least two parts which are brought together, in use, to contain the electrical connector. The parts of the casing may be secured together in any of a variety of ways, e.g. they may be snap-fitted together, or screwed or bolted together, etc. The two (or more) parts of the casing may be separate parts or they may be joined, e.g. hinged, together. The casing preferably contains sealing material which sealingly encapsulates part of the flexible envelope and the exit of the or each electrical conductor out of the envelope. The sealing material preferably also seals the electrical connector from the environment.

Generally any sealing material may be used, e.g. elastomeric material (especially natural or synthetic rubber), polymeric foam material, mastic, grease (e.g. silicone grease) or gel. The preferred sealing material comprises gel. The gel may, for example, comprise silicone gel, urea gel, urethane gel, thermoplastic gel, or any suitable gel or gelloid sealing material. Preferred gels comprise liquid (e.g. oil)-extended polymer compositions. The polymer composition of the gel may for example comprise an elastomer, or a block copolymer having relatively hard blocks and relatively elastomeric blocks. Examples of such copolymers include styrene-diene block copolymers, for example styrene-butadiene or styrene-isoprene diblock or triblock copolymers, e.g. as disclosed in International Patent Application WO 88/00603. Preferably, however, the polymer composition comprises one or more styrene-ethylene-propylene-styrene block copolymers. The extender liquids employed in the gel preferably comprise oils. The oils may be hydrocarbon oils, for example paraffinic or napthenic oils, synthetic oils for example polybutene or polypropene oils, or mixtures thereof. The preferred oils are mixtures of non-aromatic paraffins and naphthenic hydrocarbon oils. The gel may contain additives, e.g. such as moisture scavengers (e.g. Benzoyl Chloride), antioxidants, pigments and fungicides. Examples of gels are disclosed in US Patent 4634207 (Raychem).

The invention will now be described, by way of example, with reference to the accompanying drawings, of which:
Figure 1 is an illustration of a circuit board with connection wires attached to it, prior to being encapsulated by a flexible environmental gas and liquid barrier envelope;
Figure 2 is an illustration of a circuit board with an electrical connector mounted on an extension of the board, prior to being encapsulated by a flexible environmental gas and liquid barrier envelope;
Figure 3 is an illustration of a main portion of the circuit board of Figure 2 encapsulated by the flexible envelope, and with the extension carrying the connector extending out of the envelope, prior to two parts of a casing for the connector being brought together around the connector and the exit of the circuit board extension from the envelope;
Figure 4 is an illustration of the apparatus shown in Figure 3, after the two casing parts have been brought together;
Figure 5 is an illustration of one type of flexible envelope used in the invention, encapsulating a circuit board;
Figure 6 is an illustration of another type of flexible envelope used in the invention, encapsulating a circuit board; and
Figure 7 is an illustration of another apparatus according to the invention contained in an outer box.

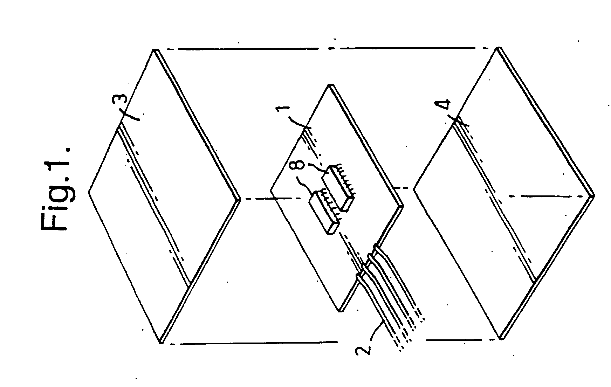

Figure 1 shows a printed circuit board 1 carrying electrical/electronic components 8, and a plurality of insulated connection wires 2 extending from the circuit board. A flexible envelope comprising two laminate sheets 3, 4 are shown disposed above and below the circuit board 1. The laminates 3, 4 may be of or similar to the material used in the product known by the Trademark, "TDUX" commercially available from Raychem. Such laminates comprise sheets of aluminium or other metal foil and polymeric strength and tie layers, such as polyester and copolymer (e.g. ethylene vinyl acetate) layers respectively.

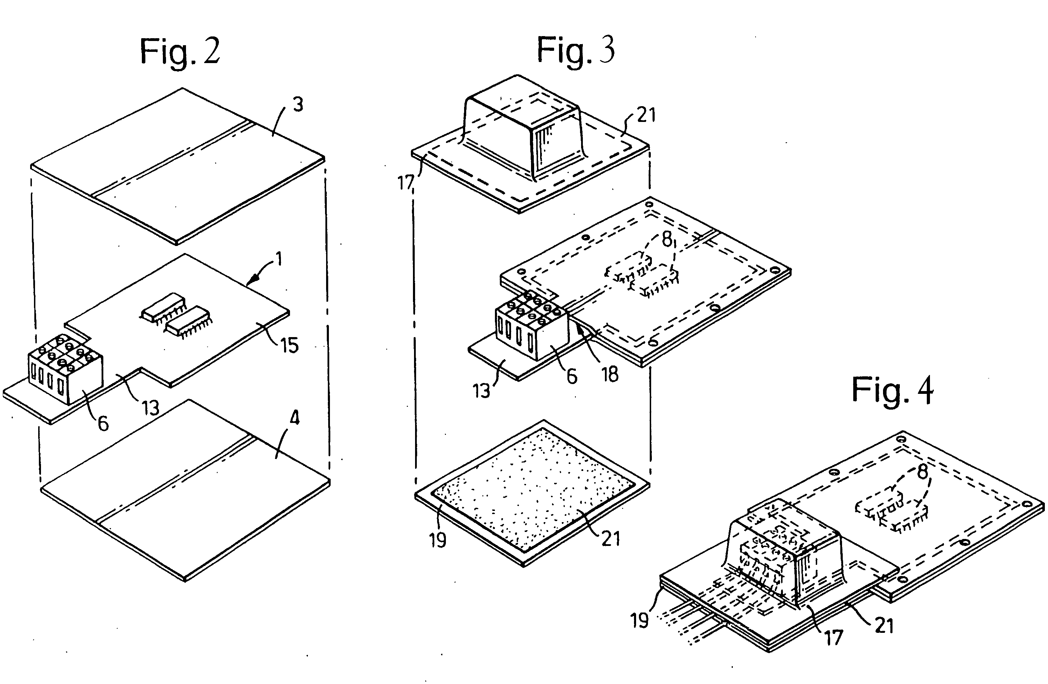

Figure 2 shows a printed circuit board 1 with sheets of laminate 3, 4 disposed above and below it. The board 1 has an extension 13 carrying a connector 6 linked to components on the board by conductive tracks (not shown). The sheets of laminate are of such a size that when brought together and sealed at the edges they will encapsulate the main portion of circuit board 1 but not the extension 13 or connector 6.

Figure 3 shows a main portion 15 of the circuit board of Figure 2 encapsulated by the flexible envelope, and with the extension 13 carrying the connector 6 extending out of the envelope 1, 3, prior to two parts 17, 19, of a casing for the connector being brought together around the connector and the exit 18 of the circuit board extension 13 from the envelope 1, 3, as shown in Figure 4. Each casing part 17, 19, has a coating of sealing material 21, which seals between the parts 17 and 19, and the exit 18 of the circuit board extension 13 from the envelope.

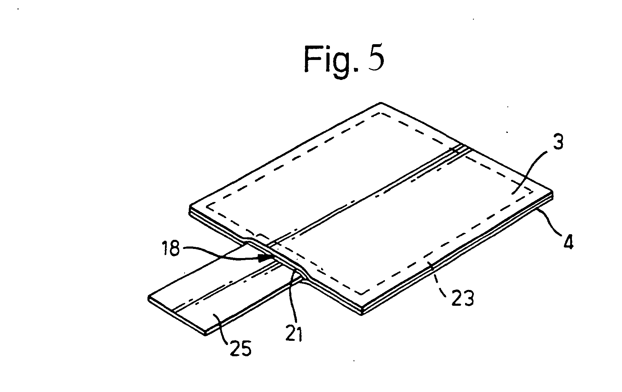

Figure 5 shows one form of flexible envelope containing a circuit board 1. The envelope comprises two sheets 3, 4, of a laminate comprising an inner aluminium layer sandwiched between two outer polyester layers, the sheets having been heat-welded together at their edges 23 in order to form the envelope. Prior to welding the sheets together, a circuit board 1, containing the electrical/electronic devices (e.g. for multiplexing telecommunications signals), was inserted between the sheets. A flat cable 25 electrically connected to the circuit board 1 extends out of the sealed flexible envelope, and sealing material 21, preferably mastic or gel, seals between the envelope and the flat cable at the exit region 18, to ensure that the interior of the envelope is completely sealed from the outside environment. Advantageously, the envelope may contain desiccant to ensure that any moisture trapped inside it, or any moisture ingressing into it, does not damage the electronics.

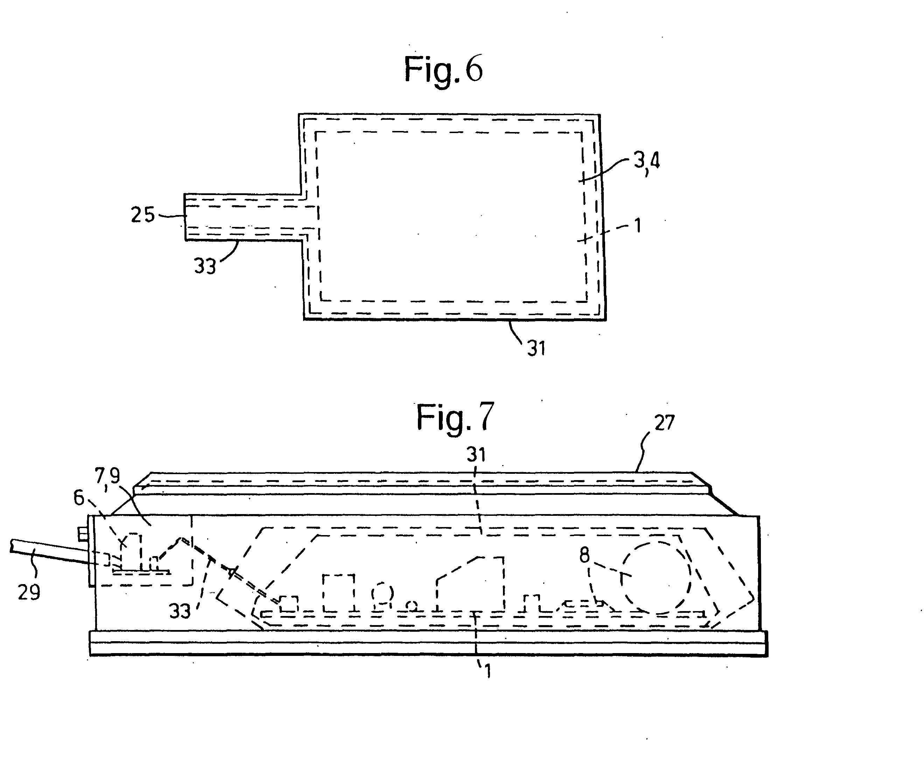

Figure 6 shows another type of flexible envelope used in the invention, encapsulating a circuit board 1 and a flat cable 25 electrically connected to the flat cable. The flexible envelope comprises a relatively wide portion 31 which encapsulates the circuit board, and extending from the wide portion a relatively narrow portion 33 which encapsulates the flat cable 25. The wide portion and the narrow portion may be portions of a single integral envelope, or they may be separate portions which are joined, e.g. welded, together.

Figure 7 shows the circuit board 1 and flat cable 25 encapsulated in the flexible envelope 3, 4 of Figure 8 contained in an outer box 27. An electrical connector 6, which is contained in a casing 7, 9 is electrically connected to the flat cable 25. The narrow portion 33 of the flexible envelope extends into the casing 7, 9.

## Claims

1. A telecommunications active electrical circuit apparatus, comprising:
(a) a circuit board (1) having active components (8);
(b) an environmental gas and liquid barrier envelope (3,4) sealingly encapsulating at least part of said circuit board (1), wherein the envelope is flexible and is formed from one or more sheets (3,4), the edges of which are bonded or welded together to provide the said encapsulation of at least part of the circuit board; and
(c) one or more electrical conductors (2) extending from the circuit board (1) out of the flexible envelope (3,4);
**characterised in that**:
(i) the apparatus also comprises an electrical connector (6) for connecting the circuit board (1) to an external system, whereby said connector (6) is located outside the flexible barrier envelope (3,4) and, at least in use, is electrically connected to the circuit board (1) by means of the one or more electrical conductors (2) extending out of the flexible envelope (3,4); and
(ii) the apparatus also comprising a casing (17,19) which, at least in use, contains the electrical connector (6) and also sealingly encapsulates part only of the flexible envelope (3,4), and the exit of the or each electrical conductor (2) out of the envelope (3,4).

2. An apparatus according to claim 1, in which the one or more electrical conductors (2) extending from the circuit board (1) out of the flexible envelope (3,4) is/are flexible.

3. An apparatus according to claim 1 or claim 2, in which the flexible envelope (3,4) comprises a relatively wide portion (31) which encapsulates the circuit board (1), or at least a main portion thereof which carries the active components (8), and extending from the wide portion (31) a relatively narrow portion (33) which encapsulates at least part of the or each electrical conductor (25).

4. An apparatus according to any preceding claim, in which said at least one electrical conductor comprises one or more wires (2) and/or at least one flat cable (25).

5. An apparatus according to any preceding claim, in which the or each said electrical conductor (2) is carried by a relatively narrow extension (13) of the circuit board (1) which extends from a relatively wide main portion (15) of the circuit board (1) which carries the active components (8).

6. An apparatus according to any preceding claim, in which the casing comprises at least two parts (17,19) which are brought together, in use, to contain the electrical connector (6).

7. An apparatus according to claim 6, in which the two or more parts (17,19) of the casing are hinged together.

8. An apparatus according to any preceding claim, in which the casing (17,19) contains sealing material, preferably gel (2), which sealingly encapsulates said part of the flexible envelope (3,4) and said exit of the or each electrical conductor (2) out of the envelope (3,4)

9. An apparatus according to any preceding claim, further comprising an outer box (27) which, at least in use, contains the circuit board (1), the flexible envelope (3,4), and preferably also the electrical connector (6).

10. An apparatus according to any preceding claim wherein the one or more sheets (3,4) of the flexible barrier envelope comprise a polymeric layer, and one or more walls containing at least one join, wherein the or each join in the wall is formed by heat welding polymeric layers of the wall(s) together.

11. An apparatus according to any preceding claim, wherein the sheets (3,4) are bonded or welded together to seal the edges such that the one or more flexible electrical conductors (2) are sealed at the edge at which they pass out from between the sheets (3,4).

## Patentansprüche

1. Aktive elektrische Schaltungsvorrichtung für die Telekommunikation, die folgendes aufweist:
(a) eine Leiterplatte (1), die aktive Bauelemente (8) hat;
(b) eine Schutzhülle (3, 4) gegenüber Gas und Flüssigkeit aus der Umgebung, die wenigstens einen Teil der Leiterplatte (1) abdichtend umkapselt, wobei die Hülle flexibel und aus einem oder mehreren Flächenkörpern (3, 4) gebildet ist, deren Ränder miteinander verklebt oder verschweißt sind, um die genannte Umkapselung wenigstens eines Teils der Leiterplatte zu bilden; und
(c) einen oder mehrere elektrische Leiter (2), die sich von der Leiterplatte (1) aus der flexiblen Hülle (3, 4) heraus erstrecken;
**dadurch gekennzeichnet, dass**:
(i) die Vorrichtung ferner einen elektrischen Verbinder (6) zum Verbinden der Leiterplatte (1) mit einem externen System aufweist, wobei der Verbinder (6) außerhalb der flexiblen Schutzhülle (3, 4) positioniert und, wenigstens im Gebrauch, mit der Leiterplatte (1) durch den einen oder die mehreren elektrischen Leiter (2), die sich aus der flexiblen Hülle (3, 4) heraus erstrecken, elektrisch verbunden ist;
und
(ii) die Vorrichtung ferner ein Gehäuse (17, 19) aufweist, das wenigstens im Gebrauch den elektrischen Verbinder (6) enthält und ferner nur einen Teil der flexiblen Hülle (3, 4) und den Austritt des oder jedes elektrischen Leiters (2) aus der Hülle (3, 4) heraus abdichtend umkapselt.

2. Vorrichtung nach Anspruch 1, wobei der eine oder die mehreren elektrischen Leiter (2), die sich von der Leiterplatte (1) aus der flexiblen Hülle (3, 4) heraus erstrecken, flexibel ist/sind.

3. Vorrichtung nach Anspruch 1 oder Anspruch 2, wobei die flexible Hülle (3, 4) folgendes aufweist: einen relativ breiten Bereich (31), der die Leiterplatte (1) oder wenigstens einen Hauptbereich davon, der die aktiven Bauelemente (8) trägt, umkapselt, und sich von dem breiten Bereich (31) erstreckend einen relativ schmalen Bereich (33), der wenigstens einen Teil des oder jedes elektrischen Leiters (25) umkapselt.

4. Vorrichtung nach einem der vorhergehenden Ansprüche, wobei der wenigstens eine elektrische Leiter einen oder mehrere Drähte (2) und/ oder wenigstens ein Flachkabel (25) aufweist.

5. Vorrichtung nach einem der vorhergehenden Ansprüche, wobei der oder jeder elektrische Leiter (2) von einem relativ schmalen Ansatz (13) der Leiterplatte (1) getragen wird, der sich von einem relativ breiten Hauptbereich (15) der Leiterplatte (1), der die aktiven Bauelemente (8) trägt, erstreckt.

6. Vorrichtung nach einem der vorhergehenden Ansprüche, wobei das Gehäuse wenigstens zwei Teile (17, 19) aufweist, die im Gebrauch zusammen gebracht werden, um den elektrischen Verbinder (6) zu enthalten.

7. Vorrichtung nach Anspruch 6, wobei die zwei oder mehr Teile (17, 19) des Gehäuses gelenkig miteinander verbunden sind.

8. Vorrichtung nach einem der vorhergehenden Ansprüche, wobei das Gehäuse (17, 19) Dichtmaterial, vorzugsweise Gel (21) enthält, das den Teil der flexiblen Hülle (3, 4) und den Austritt des oder jedes elektrischen Leiters (2) aus der Hülle heraus abdichtend umkapselt.

9. Vorrichtung nach einem der vorhergehenden Ansprüche, die ferner einen äußeren Kasten (27) aufweist, der wenigstens im Gebrauch die Leiterplatte (1), die flexible Hülle (3, 4) und bevorzugt auch den elektrischen Verbinder (6) enthält.

10. Vorrichtung nach einem der vorhergehenden Ansprüche, wobei der eine oder die mehreren Flächenkörper (3, 4) der flexiblen Schutzhülle folgendes aufweisen: eine polymere Schicht und eine oder mehrere Wände, die wenigstens eine Verbindung enthalten, wobei die oder jede Verbindung in der Wand durch Thermoverschweißen von polymeren Schichten der Wand (Wände) gebildet ist.

11. Vorrichtung nach einem der vorhergehenden Ansprüche, wobei die Flächenkörper (3, 4) miteinander verklebt oder verschweißt sind, um die Ränder derart abzudichten, dass der eine oder die mehreren flexiblen elektrischen Leiter (2) an dem Rand, an dem sie zwischen den Flächenkörpern (3, 4) austreten, abgedichtet sind.

## Revendications

1. Appareil à circuit électrique actif pour télécommunications, comportant :
(a) une plaquette à circuit (1) ayant des composants actifs (8) ;
(b) une enveloppe (3, 4) formant barrière aux gaz et liquides de l'environnement, encapsulant de façon étanche au moins une partie de ladite plaquette à circuit (1), l'enveloppe étant flexible et étant formée d'une ou plusieurs feuilles (3,4) dont les bords sont liés ou soudés entre eux pour réaliser ladite encapsulation d'au moins une partie de la plaquette à circuit ; et
(c) un ou plusieurs conducteurs électriques (2) s'étendant depuis la plaquette à circuit (1) et sortant de l'enveloppe flexible (3, 4) ;
**caractérisé en ce que** :
(i) l'appareil comporte aussi un connecteur électrique (6) destiné à connecter la plaquette à circuit (1) à un système extérieur, ledit connecteur (6) étant placé à l'extérieur de l'enveloppe flexible (3,4) formant barrière et, au moins lors de l'utilisation, étant connecté électriquement à la plaquette à circuit (1) au moyen du ou des connecteurs électriques (2) s'étendant à l'extérieur de l'enveloppe flexible (3,4) ; et
(ii) l'appareil comporte aussi un boîtier (17,19) qui, au moins lors de l'utilisation, contient le connecteur électrique (6) et encapsule également de façon étanche une partie seulement de l'enveloppe flexible (3,4) et la sortie du ou de chaque conducteur électrique (2) vers l'extérieur de l'enveloppe (3,4).

2. Appareil selon la revendication 1, dans lequel le ou les conducteurs électriques (2) s'étendant depuis la plaquette à circuit (1) vers l'extérieur de l'enveloppe flexible (3,4) est/sont flexibles.

3. Appareil selon la revendication 1 ou la revendication 2, dans lequel l'enveloppe flexible (3, 4) comporte une partie relativement large (31) qui encapsule la plaquette à circuit (1), ou au moins une partie principale de celle-ci qui porte les composants actifs (8), et, s'étendant depuis la partie large (31), une partie relativement étroite (33) qui encapsule au moins une partie du ou de chaque conducteur électrique (25).

4. Appareil selon l'une quelconque des revendications précédentes, dans lequel ledit, au moins un, conducteur électrique comporte un ou plusieurs fils (2) et/ou au moins un câble plat (25).

5. Appareil selon l'une quelconque des revendications précédentes, dans lequel le ou chaque conducteur électrique (2) est porté par un prolongement relativement étroit (13) de la plaquette à circuit (1) qui s'étend depuis une partie principale relativement large (15) de la plaquette à circuit (1) qui porte les composants actifs (8).

6. Appareil selon l'une quelconque des revendications 2 à 6, dans lequel le boîtier comporte au moins deux parties (17, 19) qui sont réunies, lors de l'utilisation, pour contenir le connecteur électrique (6).

7. Appareil selon la revendication 6, dans lequel les deux ou plus de deux parties (17, 19) du boîtier sont articulées entre elles.

8. Appareil selon l'une quelconque des revendications précédentes, dans lequel le boîtier (17, 19) contient une matière de scellement étanche, avantageusement un gel (2), qui encapsule de façon étanche ladite partie de l'enveloppe flexible (3, 4) et ladite sortie du ou de chaque conducteur électrique (2) à l'extérieur de l'enveloppe (3, 4).

9. Appareil selon l'une quelconque des revendications précédentes, comportant en outre une boîte extérieure (27) qui, au moins lors de l'utilisation, contient la plaquette à circuit (1), l'enveloppe flexible (3, 4) et avantageusement, aussi, le connecteur électrique (6).

10. Appareil selon l'une quelconque des revendications précédentes, dans lequel la ou les feuilles (3, 4) de l'enveloppe flexible formant barrière comprennent une couche polymère, et une ou plusieurs parois contenant au moins un joint, le ou chaque joint dans la paroi étant formé par soudage à chaud de couches polymériques de la ou des parois, entre elles.

11. Appareil selon l'une quelconque des revendications précédentes, dans lequel les feuilles (3, 4) sont liées ou soudées entre elles pour sceller les bords de manière que le conducteur électrique flexible ou plusieurs des conducteurs électriques flexibles (2) soient scellés de façon étanche au bord auquel ils sortent d'entre les feuilles (3, 4).
